Europäisches Patentamt

European Patent Office

Office européen des brevets

(11) Veröffentlichungsnummer: **0 115 048**
A1

(12) EUROPÄISCHE PATENTANMELDUNG

(21) Anmeldenummer: 83112981.2

(22) Anmeldetag: 22.12.83

(51) Int. Cl.³: **B 32 B 15/08**
B 29 C 27/20, C 23 C 13/02
H 05 K 9/00

(30) Priorität: 27.12.82 DE 3248147

(43) Veröffentlichungstag der Anmeldung:
08.08.84 Patentblatt 84/32

(84) Benannte Vertragsstaaten:
BE DE FR GB IT

(71) Anmelder: SIEMENS AKTIENGESELLSCHAFT
Berlin und München Wittelsbacherplatz 2
D-8000 München 2(DE)

(72) Erfinder: Bednarz, Jürgen, Dr.-Ing.
Enzianstrasse 7
D-8122 Penzberg(DE)

(72) Erfinder: Lindig, Wolfgang, Ing. grad.
Schaftlachstrasse 17
D-8000 München 70(DE)

(54) Metallisierte Formteile aus Kunststoff für technische Gehäuse zur Abschirmung gegenüber elektromagnetischen Störfeldern.

(57) Bei der Erfindung handelt es sich um Formteile (1) aus Kunststoff mit zumindest teilweiser Metallbeschichtung (2) ihrer Obeflächen. Die zu beschichtenden Oberflächen sind durch geeignete Vorbehandlung aufgerauht, so daß eine gute Haftung der Metallbeschichtung (2) an den Formteilen (1) gegeben ist. Zur Stützung dieser Metallbeschichtung (2) wird zusätzlich eine Deckschicht (3) aufgebracht. Die Formteile (1) können auch aus schrumpfbarem Material bestehen, die z.B. auch als umhüllende Gegenstände, wie Kabelgarnituren, ausgebildet sind.

EP 0 115 048 A1

SIEMENS AKTIENGESELLSCHAFT     Unser Zeichen
Berlin und München     VPA 82 P 2 1 0 0 E

Metallisierte Formteile aus Kunststoff für technische
Gehäuse zur Abschirmung gegenüber elektromagnetischen
Störfeldern.

Die Erfindung betrifft Formteile aus Kunststoff mit
zumindest teilweiser Metallbeschichtung ihrer Oberflächen, wobei diese Oberflächen durch Vorbehandlung aufgerauht sind.

Aus der DE-PS 19 09 489 ist ein Verfahren zur Herstellung von durch Wärme rückstellfähigen Formteilen (aus
Polymeren) mit geringem elektrischen Widerstand bekannt.
Dort wird wenigstens ein Teil der rückstellfähigen Formteiloberfläche mit einem dünnen Film eines Metalls beschichtet. Die Beschichtung wird auf verschiedene Weise
aufgebracht, wobei die zu beschichtende Oberfläche vorher entsprechend behandelt wird. Trotz einer Vorbehandlung der Oberfläche, z.B. durch Aufrauhen mittels ätzender oder oxidierender Flüssigkeiten, besteht die Gefahr,
daß die Metallbeschichtung zumindest teilweise beschädigt wird oder sich auch ablöst, wenn die Formteile
durch den Schrumpfvorgang ihre Form verändern.

Aufgabe der Erfindung ist nun, Formteile aus Kunststoff
mit einer Metallbeschichtung zu schaffen, bei denen die
Metallschicht so festhaftend aufgebracht ist, daß auch
bei Formänderung dieser Formteile eine Beschädigung
oder ein Ablösen der Metallbeschichtung unterbleibt,
wobei diese Oberflächen zusätzlich einen Schutz gegen
mechanische Einwirkung erhalten sollen. Die gestellte
Aufgabe wird nun gemäß der Erfindung mit Formteilen der

22.12.1982 / Sef 1 Kom

eingangs geschilderten Art dadurch gelöst, daß eine
Deckschicht über der auf der Oberfläche des Formteiles
angebrachten Metallbeschichtung angeordnet ist.

Weiter stellt sich die Aufgabe, ein Verfahren zum Herstellen solcher Formteile zu finden. Ein Verfahren löst
die weitere Aufgabe erfindungsgemäß dadurch, daß die
zu beschichtende Oberfläche zunächst aufgerauht, daß
dann die Metallbeschichtung und daß anschließend die
Deckschicht aufgebracht wird.

Die Formteile gemäß der Erfindung weisen nun gegenüber
dem genannten Stand der Technik und den weiteren an
sich bekannten anschließend angedeuteten Verfahren Vorteile auf, die  das Problem der Abschirmung gegenüber
elektromagnetischen Störfeldern erheblich vereinfachen.
Für technische Gehäuse der Nachrichtentechnik, wie Verbindungsmuffen der PCM-Antennen- und Lichtwellenleiter-
Verstärkertechnik ist vielfach die Abschirmung hochfrequenter elektromagnetischer Störfelder erforderlich. Erfahrungsgemäß müssen zur ausreichenden Abschirmung Dämpfungen der Störfelder von ca 50 bis 95 dB erreicht werden. So sind z.B. in allgemeiner Weise Metallgehäuse
oder Metallgitter bekannt, die zur Abschirmung hergenommen werden. Schwierigkeiten ergeben sich jedoch bei
den Trennstellen im Gehäuse und bei Durchführungen, wo
besondere konstruktive Maßnahmen erforderlich sind, um
eine ausreichende Abschirmung zu gewährleisten. Das Frequenzspektrum der Störfelder, die im allgemeinen abgeschirmt werden müssen, reicht vom kHz bis GHz-Bereich.
Auch werden leitfähige Lacke zur Oberflächenbehandlung
von Gehäusen verwendet, doch ist diese Art der Abschirmung sehr teuer und genügt nicht allen Abschirmanforderungen. Außerdem ist die Abriebfestigkeit derartiger
Lacke sehr gering. Ein weiteres bekanntes Aufbringen
von Metallen auf Kunststoff ist das sogenannte Flammspritzen (Schoopen) mit Metallen, z.B. Zink, Zinn oder Aluminium. Dieses Verfahren ist ebenfalls sehr teuer und gibt dem Gehäuse eine rauhe, rißanfällige Oberfläche. Bei hohen Anforderungen an die Dämpfung treten durch die inhomogene Oberfläche Probleme auf. Ein weiterer Versuch, eine Abschirmung gegen Störfelder zu erreichen, geht dahin, die Kunststoffe selbst durch Zusätze wie Metall oder Ruß leitfähig zu machen. Diese Materialien ergeben jedoch z.Zt. keine sichere und ausreichende Dämpfung der elektromagnetischen Felder im niederfrequenten Bereich. Schließlich sind noch metallisierte bzw. metallkaschierte Folien und Pappen bekannt, die zur Dämpfung von Störfeldern verwendet werden. Eine sichere Abschirmung, wie sie bei Verstärkern der Antennen- und PCM-Technik verlangt wird, ist jedoch nicht gewährleistet. Außerdem erfordert die Anwendung zusätzliche Arbeitsgänge bei der Montage. Die geschilderten Versuche zur Herstellung einer Abschirmung sind wohl allgemeiner Art und so bekannt, daß ein weiterer Nachweis nicht erforderlich erscheint.

Bei vorliegender Erfindung werden diese anstehenden Probleme weitgehend gelöst; denn es ist eine ausreichende Dämpfung gegenüber Störfeldern gewährleistet und die Haftung der Metallauflage auf den zu beschichtenden Oberflächen der Formteile ist infolge der Aufrauhung der Oberfläche im Zusammenhang mit einer weiteren Deckschicht auf der Metallbeschichtung als ausreichend anzusehen. Diese Deckschicht kann z.B. aus elastischem oder plastischem Material bestehen. Vorzugsweise findet ein Schmelzkleber Anwendung, der bei Wärme aktivierbar ist und der Metallbeschichtung ebenfalls wie die anderen Materialien eine ausreichende Stützung gibt. Weiterhin ist die Verwendung von elektrisch leitfähigem Material, z.B. leitfähigen Kunststoffmassen, möglich. Der Einsatz derartiger Massen ergibt auch in den Einführungsbereichen eine ausreichende "elektromagnetische Abdichtung". Die Erfindung ermöglicht u.a. auch eine preisgünstige und sichere Abschirmung gegenüber elektromagnetischen Störfeldern bei technischen Gehäusen unter Ausnutzung der Vorteile der Schrumpftechnologie. Hierbei wird nach der üblichen Aufweitung der Formteile die zu beschichtende Oberfläche des Gehäuses durch chemische, physikalische oder mechanische Verfahren bzw. durch eine Kombination aus diesen drei Verfahren vorbehandelt. Diese vorbehandelten Oberflächen gewährleisten eine genügende Verankerung der anschließend aufzubringenden Metallbeschichtung. Bei den üblichen Polyolefincompounds erwies sich zur Aufrauhung der Oberfläche die Sandstrahlung als optimal. Die darauf folgende Metallisierung kann entweder durch Aufdampfen, Galvanisieren, chemische Metallisierung oder durch Aufbringen eines leitfähigen Lackes oder auch durch eine Kombination dieser Methoden erfolgen. Weiterhin ist es möglich, metallisierte Gewebe auf die zu beschichtenden Formteile aufzubringen oder einzuarbeiten. Besonders vorteilhaft erweist sich eine chemische Vorverkupferung der Formteiloberflächen und eine anschließende chemische Vernickelung. Durch die entsprechende Vorbehandlung der Formteiloberflächen in der geschilderten Weise ist die Metallschicht ausreichend fest und formschlüssig mit dem Kunststoff verbunden. Anschließend wird auf der Metallbeschichtung eine weitere Deckschicht aufgebracht, die aus elastischen, plastischen und/oder klebefähigen Materialien besteht.

In einer Figur wird nun die Erfindung näher erläutert.

In dieser Figur ist ein Ausschnitt eines Formteils 1 dargestellt, dessen eine Oberfläche 4 im Normalzustand belassen ist, während die zweite Oberfläche 6 mit Hilfe eines der bereits genannten Verfahren, z.B. durch Sandstrahlen, aufgerauht ist. Diese Oberfläche 6 weist somit eine unregelmäßige Struktur mit Löchern, Hinterschneidungen u. dgl. auf. Auf diese aufgerauhte Oberfläche 6 ist die Metallbeschichtung 2 aufgebracht, die sich formschlüssig in die Unebenheiten der aufgerauhten Oberfläche 6 einfügt und anschmiegt. Auf diese Metallbeschichtung 2 ist erfindungsgemäß die Deckschicht 3, z. B. eine Schmelzkleberschicht aufgebracht, die der darunterliegenden Metallschicht 2 eine zusätzliche Stützung gewährleistet. Diese Stützung durch eine Deckschicht 3 aus Schmelzkleber ist besonders dann von Vorteil, wenn das Formteil 1 aus wärmeschrumpfbarem Material besteht, da die Schmelzkleberschicht 3 während des Schrumpfvorganges durch Wärmeeinwirkung erweicht und der Formänderung des Formteils 1 folgt. Hierbei ist die Stützwirkung der Schmelzkleberschicht 3 für die Metallbeschichtung 2 von besonderem Vorteil, da z.B. ein Ablösen der Metallbeschichtung 2 infolge der Überspannung durch die Schmelzkleberschicht 3 verhindert wird. Nach dem Schrumpfprozeß verbleibt die Metallbeschichtung 2 infolge ihrer guten Haftung auf dem Kunststoff und durch die Stützwirkung der Deckschicht 3 für den geforderten Abschirmeffekt gegenüber elektromagentischen Störfeldern ausreichend unversehrt. Ablöseerscheinungen bzw. Einreißen der Metallbeschichtung 2 während des Schrumpfens sind weitestgehend verhindert.

Bei Formteilen 1, die als umhüllende Gegenstände ausgebildet sind, wie z.B. Kabelgarnituren, kann die Deckschicht 3 beispielsweise aus einer Schmelzkleberschicht bestehen, die eventuell auch leitfähig gemacht ist. Sie/ kann in vorteilhafter Weise an den Trennstellen gleichzeitig als Dichtungsmittel verwendet und angesehen werden, wobei die Oberfläche 5 der Schmelzkleberschicht 3 am umhüllten Gegenstand dichtend anliegt. Bei Kabeleinführungen von Kabelgarnituren kann somit die Schrumpfgarnitur auch im Einführungsbereich direkt auf die eingeführten Kabel herabgeschrumpft werden, wobei ohne zusätzliche Maßnahmen sofort die Dichtung mit Hilfe der Schmelzkleberbeschichtung 3 erfolgt. Durch die Leitfähigkeit der Deckschicht 3 ist gleichzeitig eine ausreichende Abschirmung gegenüber elektromagnetischen Störfeldern gegeben. Bei diesen umhüllenden Gegenständen muß selbstverständlich die Metallbeschichtung 2 und die darüber liegende Schmelzkleberbeschichtung 3 auf der Innenseite der Formteile angeordnet sein. Dies ist im übrigen auch bei nichtschrumpfbaren Formteilen von Vorteil, da dann die Beschichtungen gegen mechanische Beschädigung geschützt sind.

1 Figur
22 Patentansprüche

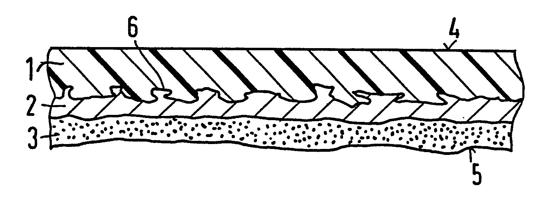

Patentansprüche

1. Formteile aus Kunststoff mit zumindest teilweiser Metallbeschichtung ihrer Oberflächen, wobei diese Oberflächen durch Vorbehandlung aufgerauht sind, d a d u r c h   g e k e n n z e i c h n e t , daß eine Deckschicht (3) über der auf der Oberfläche des Formteiles (1) angebrachten Metallbeschichtung (2) angeordnet ist.

2. Formteile nach Anspruch 1, d a d u r c h   g e - k e n n z e i c h n e t ,   daß sie aus schrumpfbarem Material bestehen und daß die Metallbeschichtung (2) und die Deckschicht (3) im gedehnten Zustand des Formteiles (1) aufgebracht sind.

3. Formteile nach einem der vorhergehenden Ansprüche, d a d u r c h   g e k e n n z e i c h n e t ,   daß sie als umhüllende Gegenstände ausgebildet sind und daß die Metallbeschichtung (2) und die darüberliegende Deckschicht (3) auf der Innenseite der Gegenstände angeordnet sind.

4. Formteile nach einem der vorhergehenden Ansprüche, d a d u r c h   g e k e n n z e i c h n e t ,   daß mehrere aufeinanderfolgende Metallbeschichtungen (2) angeordnet sind.

5. Formteile nach einem der vorhergehenden Ansprüche, d a d u r c h   g e k e n n z e i c h n e t ,   daß die Deckschicht (3) aus elastischem Material besteht.

6. Formteile nach einem der Ansprüche 1 bis 4, d a - d u r c h   g e k e n n z e i c h n e t ,   daß die Deckschicht (3) aus plastischem Material besteht.

7. Formteile nach einem der Ansprüche 1 bis 4, d a - d u r c h   g e k e n n z e i c h n e t , daß die Deckschicht (3) aus elektrisch leitendem Material besteht.

8. Formteile nach einem der Ansprüche 1 bis 4, d a - d u r c h   g e k e n n z e i c h n e t , daß die Deckschicht (3) aus einem Schmelzkleber besteht.

9. Verfahren zum Herstellen von Formteilen nach einem der vorhergehenden Ansprüche, d a d u r c h   g e - k e n n z e i c h n e t , daß die zu beschichtende Oberfläche (6) zunächst aufgerauht, daß dann die Metallbeschichtung (2) und daß anschließend die Deckschicht (3) aufgebracht wird.

10. Verfahren nach Anspruch 9, d a d u r c h   g e - k e n n z e i c h n e t , daß das Aufrauhen der Oberfläche (6) chemisch erfolgt.

11. Verfahren nach Anspruch 9, d a d u r c h   g e - k e n n z e i c h n e t , daß das Aufrauhen der Oberflächen (6) physikalisch erfolgt.

12. Verfahren nach Anspruch 9, d a d u r c h   g e - k e n n z e i c h n e t , daß das Aufrauhen der Oberflächen (6) mechanisch erfolgt.

13. Verfahren nach Anspruch 9, d a d u r c h   g e - k e n n z e i c h n e t , daß das Aufrauhen der Oberflächen (6) mit einer Kombination der in den Ansprüchen 9 bis 12 bezeichneten Verfahren erfolgt.

14. Verfahren nach Anspruch 12, d a d u r c h   g e - k e n n z e i c h n e t , daß das Aufrauhen der Oberflächen (6) durch Bürsten erfolgt.

0115048

15. Verfahren nach Anspruch 12, d a d u r c h   g e - k e n n z e i c h n e t , daß das Aufrauhen der Oberflächen (6) durch Sandstrahlung erfolgt.

16. Verfahren nach einem der vorhergehenden Ansprüche, d a d u r c h   g e k e n n z e i c h n e t , daß das Aufbringen der Metallbeschichtung (2) durch Aufdampfen erfolgt.

17. Verfahren nach einem der Ansprüche 9 bis 15, d a - d u r c h   g e k e n n z e i c h n e t , daß das Aufbringen der Metallbeschichtung (2) durch Galvanisieren erfolgt.

18. Verfahren nach einem der Ansprüche 9 bis 15, d a d u r c h   g e k e n n z e i c h n e t , daß das Aufbringen der Metallbeschichtung (2) durch chemische Metallisierung erfolgt.

19. Verfahren nach einem der Ansprüche 9 bis 15, d a d u r c h   g e k e n n z e i c h n e t , daß ein leitfähiger Lack als Metallbeschichtung (2) aufgebracht wird.

20. Verfahren nach einem der Ansprüche 9 bis 15, d a d u r c h   g e k e n n z e i c h n e t , daß das Aufbringen der Metallbeschichtung (2) durch eine Kombination der in den Ansprüchen 16 bis 19 bezeichneten Verfahren erfolgt.

21. Verfahren nac h einem der Ansprüche 9 bis 15, d a d u r c h   g e k e n n z e i c h n e t , daß ein metallisiertes Gewebe in die Oberfläche (6) der Formteile eingearbeitet wird.

22. Verfahren nach Anspruch 18, d a d u r c h g e -
k e n n z e i c h n e t , daß zunächst eine chemische
Vorverkupferung und darüber eine chemische Vernickelung
erfolgt.

**0115048**
Nummer der Anmeldung

**EUROPÄISCHER RECHERCHENBERICHT**

**Europäisches Patentamt**

EP  83 11 2981

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| D,X | DE-B-1 909 489  (RAYCHEM CORP.)  * Spalte 2, Zeilen 53-59; Spalte 3, Zeilen 11-41, 46-59; Spalte 7, Beispiel * | 1,2,9, 10,16 | B 32 B  15/08 B 29 C  27/20 C 23 C  13/02 H 05 K   9/00 |
| | --- | | |
| A | DE-A-2 927 177  (TOYO BOSEKI K.K.)  * Seite 4, Zeilen 15-30; Seite 5, Zeilen 15-23, 30-35; Seite 6, Zeilen 25-28; Seite 13, Zeilen 1-22; Seite 15, Zeilen 5-15 * | 1,5,6, 16-18 | |
| | --- | | |
| A | FR-A-2 318 734  (RCA CORP.)  * Seite 1, Zeilen 1-9; Seite 6 * | 1,4,6, 16,22 | |
| | --- | | **RECHERCHIERTE SACHGEBIETE (Int. Cl. ³)** |
| A | FR-A-2 454 449  (SCHOELLER & CO.)  * Seite 1, Zeilen 8-22; Seite 2, Zeilen 10-20 * | 10-12 | B 32 B C 23 C |
| | --- | | |
| A | W. GOLDIE: "Metallic coating of plastics", Band 1, Kapitel 3, 1968, Seiten 22-30, Electrochemical Publications Ltd., Hatch End, Middlesex, GB.  * Seiten 22,23 * | 10 | |
| | --- | | |
| A | W. GOLDIE  * Seiten 26,27 * | 11 | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 30-03-1984 | VAN THIELEN J.B. |

Europäisches
Patentamt

**EUROPÄISCHER RECHERCHENBERICHT**

**0115048**
Nummer der Anmeldung

EP 83 11 2981

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | W. GOLDIE<br>* Seiten 23-26 *<br><br>----- | 12,15 | |

RECHERCHIERTE
SACHGEBIETE (Int. Cl. ³)

Der vorliegende Recherchenbericht wurde für alle Patentansprüche erstellt.

| Recherchenort<br>DEN HAAG | Abschlußdatum der Recherche<br>30-03-1984 | Prüfer<br>VAN THIELEN J.B. |
|---|---|---|

KATEGORIE DER GENANNTEN DOKUMENTEN
X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
    nach dem Anmeldedatum veröffentlicht worden ist
D : in der Anmeldung angeführtes Dokument
L : aus andern Gründen angeführtes Dokument

 

& : Mitglied der gleichen Patentfamilie, überein-
    stimmendes Dokument

EPA Form 1503 03 82